Europäisches Patentamt

European Patent Office

Office européen des brevets

(11) Publication number: **0 321 862**
**A2**

# EUROPEAN PATENT APPLICATION

(21) Application number: **88120991.0**

(22) Date of filing: **15.12.88**

(51) Int. Cl.⁴: **H01L 39/12 , H01L 39/24**

Claims for the following Contracting State: ES.

(30) Priority: **22.12.87 US 136626**

(43) Date of publication of application:
**28.06.89 Bulletin 89/26**

(84) Designated Contracting States:
**AT BE CH DE ES FR GB GR IT LI LU NL SE**

(71) Applicant: **W.R. Grace & Co.-Conn. (a Connecticut corp.)**
**Grace Plaza 1114 Avenue of the Americas New York New York 10036(US)**

(72) Inventor: **Dolhert, Leonard Edward**
**13324 Elliott Drive**
**Clarksville, MD 21029(US)**
Inventor: **Rice, Roy Warren**
**5411 Hopark Drive**
**Alexandria, VA 22310(US)**
Inventor: **Block, Jacob**
**14112 Parkvale Road**
**Rockville, MD 20853(US)**

(74) Representative: **Abitz, Walter, Dr.-Ing. et al**
**Abitz, Morf, Gritschneder, Freiherr von Wittgenstein Postfach 86 01 09**
**D-8000 München 86(DE)**

(54) **Use of barium peroxide in superconducting Y1Ba2Cu3Ox and related materials.**

(57) Improved process for making superconductors. A powdered peroxide, "MO₂", is admixed with two oxide powders, "L oxide" and "A oxide"; where M is at least one metal of the group Ba, Mg, Ca, and Sr - preferably Ba; O is oxygen; L is at least one metal of the rare earth group, including scandium and yttrium - preferably yttrium; and A is at least one metal of the group Cu, Ag, and Au - preferably Cu. The powdered mixture becomes superconducting when shaped and fired. The peroxide oxygen helps furnish oxygen requirements in the final superconducting composition, e.g., $Y_1Ba_2Cu_3O_x$. Barium peroxide has a relatively low melting point and thus aids in achieving efficient sintering with enhanced homogeneity. The invention process results in new compositions.

# USE OF BARIUM PEROXIDE IN SUPERCONDUCTING $Y_1 Ba_2 Cu_3 O_x$ AND RELATED MATERIALS

## FIELD OF THE INVENTION

This invention relates to the preparation of superconducting ceramics and more particularly to an improvement in preparing the metal oxide system generically represented by L.M.A.O. where O is oxygen and (e.g.) L may be yttrium, M may be barium, and A, copper.

## BACKGROUND OF THE INVENTION

It has long been known that the effective resistivity of certain metals was sometimes substantially eliminated when the metal was exposed to low temperature conditions. Of particular interest were the metals and metal oxides which can conduct electricity under certain low temperature conditions with virtually no resistance. These have become known as superconductors. Certain metals, for example, are known to be superconductive when cooled to about 4° on the Kelvin scale (°K), and certain niobium alloys are known to be superconductive at about 15° K, some as high as about 23° K. More recently, an oxide containing lanthanum, barium, and copper was discovered which became superconductive at temperatures of about 30° K, and in some circumstances at temperatures of about 20° higher. Current advances have identified materials which become superconductive at temperatures near 100° K, such that liquid nitrogen cooling could be used. Of special interest are ceramic materials which have reduced electrical resistance properties that are stable over time such that they could be developed for use in practical applications. While the phenomena of reduced electrical resistance and even superconductivity have now been observed at liquid nitrogen temperatures or above, these properties are still considered to be achieved primarily at low temperatures when compared to ambient conditions. However, there is some indication that ceramic materials might be formulated which can reliably exhibit reduced electrical resistance and perhaps superconductivity at ambient conditions.

A composition having an approximate unit cell formula of $Y.Ba_2.Cu_3.O_z$, where z is typically about 7, and various related materials, represents a particularly promising group of ceramics for superconducting applications. The compositions are typically formulated from precursors which can be mixed to provide the desired ceramic. In one formulation for these ceramic materials, for example, carbonate and/or oxide powders of the solid elements are mixed and raised to a temperature of about 1,000° C, driving off volatile materials, such as carbon dioxide. The mixture is reground and reheated, ordinarily several times, to improve the intimacy of the mixture, and then can be pelletized, sintered for several hours, and then gradually cooled to below 250° C.

Pellets have proven convenient to research applications properly involving ceramic superconductive materials since they can be readily formed by pressing together the powdered materials and binding them by a sintering process. These ceramic materials are typically brittle such that they are also more readily handled in pellet form. However, commercial applications of superconductors are likely to require substantial quantities of such materials in useful shapes such as tubes, rods, wires, or sheets, and other techniques for conveniently and reliably shaping these ceramic materials, while maintaining their ability to conduct electricity with reduced resistance, are being sought.

Reportedly, one procedure has been developed in which the ceramic powder is encased in a thin tube of metal such as silver, and then drawing the filled tube to form a wire. Evaporative techniques have also been reportedly used to produce films of superconducting materials from multiphase material comprising yttrium, barium, copper, and oxygen. In still another procedure, the ceramic powder, or even its ingredients, are mixed into an organic binder such as polyethylene glycol which is then extruded to form a plastic wire. After the wire is formed into the desired shape, the binder is burnt off and the residual powders are sintered to form the product filament. Tapes have also been produced by embedding ceramic particles in organic material to produce a flexible tape which can be shaped and then sintered. The conductive performance of the final ceramic material is known to be dependent upon the uniformity of element distribution throughout the composition. A common objective in any of the techniques for formulating and processing superconductive materials is to assure intimate mixing of precursor materials to provide a relatively homogeneous ceramic product.

Wu et al, Superconductivity at 93K in a New Mixed Phase Y-Ba-Cu-O Compound System at Ambient Pressure, Physical Review Letters, 58, 908-910 (2 March 1987), discloses making the title compounds by solid state reaction of $Y_2O_3$, $BaCO_3$, and $CuO$.

Engler et al, Superconductivity above Liquid Nitrogen Temperature: Preparation and Properties of a Family of Perovskite-Based Superconductors, J. Am. Chem. Soc. 109, 2848-2849 (1987), mixes $Y_2O_3$, $BaCO_3$, and $CuO$ in a ball mill to give a 1:2:3 ratio of Y, Ba, Cu. The powder was heated in an alumina boat at 950°C, and the resulting black powder was reground and heated again.

Wang et al, Comparison of Carbonate, Citrate, and Oxalate Chemical Routes to the High-$T_c$ Metal Oxide Superconductors $La_{2-x}Sr_xCuO_4$, Wu et al, Inorg. Chem. 26, 1474-1476 (1987). This reference uses a carbonate precipitation technique. The precipitant was $K_2CO_3$. According to the paper, it was necessary to wash the precipitate repeatedly, an obvious disadvantage in production work. Washing was necessary because potassium adversely affects superconductivity properties of the finished material.

## SUMMARY OF THE INVENTION

A mixture of L.M.A oxides is shaped and heat-treated to make a superconductor. In this mixture the M oxide is a peroxide, which confers several benefits, including holding the shape together before and during firing and, supplying free oxygen during heating. Barium peroxide is particularly noteworthy in that it facilitates sintering because of its relatively low melting point, thereby reducing time in the furnace. M is at least one metal of the group Ba, Mg, Ca, and Sr and is preferably Ba; L is at least one metal of the rare earth group (elements with atomic numbers 57-71), including scandium and yttrium and is preferably yttrium; A is at least one metal of the group Cu, Ag, and Au, preferably Cu.

It has been reported that $BaO_2$ has been used as a Ba source to make a $Y_1Ba_2Cu_3O_x$ powder, but so far as we are aware, no one previously made such $BaO_2$-containing pellet or other shape and fired the shape directly to make a superconductor. We differ from prior practice in that we heat the $BaO_2$-containing shape and by that one step make a superconductor, whereas the prior art (a) mixed the powders, (b) calcined the mixed powders, (c) shaped the calcined powders, and (d) heated the shape to achieve superconductivity. Note that in the prior art process several steps were required to make a superconducting shape. Our invention makes a superconducting shape in essentially one step, i.e., simply by heating the $BaO_2$-containing shape. Note further that in the prior art process the peroxide oxygen is lost in the first calcination and is unavailable to boost oxygen content for the final superconducting composition. In our composition, on the contrary, the peroxide oxygen is available during the step (i.e., the first and only firing) in which superconductivity is developed.

## DETAILED DESCRIPTION OF THE INVENTION

In a generic sense we intimately mix together a peroxide, $MO_2$; an L oxide; and an A oxide, where M is at least one member of the group Ba, Mg, Ca, and Sr, preferably Ba; L is at least one metal of the rare earth group (elements with atomic numbers 57-71), including scandium and yttrium, and is preferably yttrium; and A is at least one metal of the group Cu, Ag, and Au, preferably Cu. The oxides should provide an atomic ratio in the range of $L_a:M_b:A_c$ where a is about 0.8 - 2.2, preferably about 1; b is about 1.8 - 2.2, preferably about 2; and c is about 2.7 - 3.3, preferably about 3. This results in an amount of oxygen in the heat-treated product equal to about 7 (or a little less) atoms per atom of L.

Our powders are suitably about 100-mesh (i.e., about 90% will pass a 100-mesh U. S. Screen). The reagents may usually be purchased in this form as reagent-grade oxides from various commercial suppliers. These materials contain at most only trace impurities, which do not affect properties of the finished superconductor.

Next, we form the powder mixture into a pellet or other shape by compression or other conventional techniques.

The pellets in the examples were made with a Carver laboratory hydraulic press, and were about $\frac{1}{2}$-1" in diameter and $\frac{1}{4}$" in height. These dimensions are of course not critical.

This peroxide-containing shape is the crux of our invention. When such shape is heat-treated, it ipso facto becomes superconducting. Further processing for superconductivity is unnecessary.

The heat-treated shape has substantially the metal ratios of the powder mixture. The oxygen content is lower, since the peroxide oxygen is diminished. Thus the heat-treated shape has the composition $L_aM_bA_cO_x$ where L, M, and A and a, b, and c are as above defined, and x is about 7.

By shape we mean products made when intimate mixtures of the above powders are pressed or adhered together. This is commonly done by compressing the powdered mixture into pellets, bars, briquets, and the like. Also, shapes can be made by extrusion as, e.g., rods, tubes, etc.

In a preferred aspect of our peroxide-containing shape, the L oxide/A oxide can be furnished as a precalcined powder (Cf. Example 2).

As we have mentioned, barium peroxide has reportedly been admixed with $Y_2O_3$ and CuO powders, and then the powdered mixture first fired, then the fired mixture shaped, the shape re-fired with or without regrinding, and so on, until superconductivity is achieved. So far as we are aware, no one has previously shaped a powdered mixture of $BaO_2$, $Y_2O_3$, and $CuO$. Yet, this is the simplest and most efficient way of utilizing the unique contributions of $BaO_2$. Summarily stated, when such shape is sintered, it becomes superconducting. Further processing is unnecessary. While we do not wish to be bound by any particular mechanism, we believe that $BaO_2$ accomplishes this by (a) decomposing to provide free oxygen within the sample body during sintering, thereby helping maintain oxygen requirements in the final composition $Y_1Ba_2Cu_3O_x$; (b) melting at a relatively low temperature (around $450°C$) thereby aiding sintering and thus assisting homogeneity; (c) reducing furnace time in that byproduct gases (e.g., $CO_2$, nitrogen oxides, water, etc.) need not be driven off.

After the pellet or other shape is made, it is heat-treated (i.e., calcined, fired, or sintered) in a furnace, in air or oxygen at $925 - 1,025°C$, preferably about $950-975°C$, and held there for about 1 - 2 hours, suitably about 1.5 hours. Longer times can be used, but are a waste of energy. Following this heat treatment, the shape is allowed to cool, e.g., to room temperature. At this point a test of the shape will show that it is superconducting.

For the aforesaid heat treatment the shape is preferably placed in an inert container, e.g., an alumina boat.

From the foregoing description it will be evident that our process introduces no extraneous substances into the L.M.A oxide mix; viz., no cations other than L.M.A enter the system, and no anions whatever are used. The process thus results in an oxide mix of extraordinary purity at all stages, from initial powder mixture to finished fired shape.

The following examples illustrate without limiting the invention.

### Example 1

Powders:
$Y_2O_3$, 0.8184 g
$BaO_2$, 2.4537 g
$CuO$, 1.7293 g

The powders, proportioned in the proper ratio to make $Y_1Ba_2Cu_3O_x$, were mixed, then pressed into a pellet. The pellet was placed in a furnace for sintering at $950-975°C$ for 1 hour, 28 minutes, in air. The heat-treated pellet was allowed to cool in the furnace. The solidified body was cooled in liquid nitrogen and was able to float a magnet above its surface.

### Example 2

Powders:
$BaO_2$,        0.7363 g
$Y_1Cu_3O_y$,        0.7640 g

The $Y_1Cu_3O_y$ powder was previously prepared by calcining together $Y_2O_3$ and $CuO$ in a molar ratio of 1:6, at $950-975°C$ in air for 1.5 hours.

The above materials provided the desired ratio, $Y_1Ba_2Cu_3O_x$; the components were mixed as in Example 1, pressed into a pellet, and the pellet was heated at $950-975°C$ for 1 hour 28 minutes, during which time it sintered. When the body was cooled in liquid nitrogen, it floated a magnet above its surface.

### Example 3

A run was made following the procedure of Example 1 except that sufficient Y was used to provide a $Y_2Ba_2Cu_3O_x$ ratio in the powdered mixture, viz., $Y_2O_3$,        5.46 g
$BaO_2$        8.20 g
$CuO$,        5.77 g

Following sintering and cooling, the pellet (19.4360 g) showed superconductivity by the Levitation Test below.

### Example 4
(Control)

A run was made following the procedure of Example 1 except that BaO was used instead of $BaO_2$. It was not possible to make a suitable pellet owing to the hydroscopicity of the BaO, which caused the attempted pellet to crumble before and during heat treatment. Further, even before it disintegrated, the pellet absorbed water from the atmosphere so rapidly that it could not be accurately weighed.

### Extraneous Materials

Prior art processes conventionally enhance homogeneity by grinding the calcined intended superconductor, followed by recalcining. In some instances this sequence may be repeated several times. It is known that improved homogeneity in the general case enhances superconductivity. The problem here is that effective grinding inevitably and inherently introduces impurities into the ceramic, simply by impacting the ceramic between the balls and walls (or other grinding surfaces) of the grinding mill. It is known, for example, that silica or stainless steel balls in a ball mill lose significant mass over a period of use. This mass, of course, disappears into whatever was being milled. Mills that comminute by particle self-impact lose metal by wall-scouring, particularly in the area of stream entry. If the product is ground in a ball mill using quartz or silica balls, some of the impurity is silica.

Thus, the firing-grinding-refiring technique rapidly achieves a balance: improvement in homogeneity tends to be matched by contamination build-up that cancels part or all of the improvement.

Our process avoids the grinding problem in the general case. Our heat-treated product, can, of course, be subjected to the conventional grinding-shaping-refiring cycle, but this is superfluous.

Levitation Test for Superconductivity

Various tests are available for the determination of superconductivity. One of these tests is conventional, simple, and is accepted in the art as definitive. We used this, the so-called levitation test, in our determinations, and we describe it below.

The pellet (e.g., the heat-treated shape of Example 1) is placed in the center of a glass dish, and then liquid nitrogen ($77^\circ$ K) is poured into the dish. The pellet bubbles a bit at first, as the nitrogen boils on contact, and as surface air is flushed from the pellet. In a few minutes gas evolution diminishes to nearly zero, and the pellet may be assumed to be chilled to approximately the temperature of liquid nitrogen. A chip of a rare earth magnet is now dropped gently over the pellet. If the magnet levitates, i.e., hovers in the air over the pellet - the so-called "Meissner Effect" - the pellet is superconducting.

**Claims**

1. Shape adapted to become superconducting by heat treatment, said shape consisting essentially of an adhered intimate mixture of powdered $MO_2$, L oxide, and A oxide, where M is at least one metal of the group Ba, Mg, Ca, and Sr; O is oxygen; L is at least one metal of the rare earth group, including scandium and yttrium; A is at least one metal of the group Cu, Ag, and Au; where L:M:A is present in a respective atomic ratio of about a:b:c, where a is about 0.8 - 2.2, b is about 1.8 - 2.2, and c is about 2.7 - 3.3.

2. Shape according to Claim 1 in which a is about 1, b is about 2, and c is about 3.

3. Shape according to Claim 2 in which L is yttrium, M is barium, and A is copper.

4. Shape according to Claim 1 wherein L oxide and A oxide are precalcined together.

5. Powdered composition consisting of intimate mixture of $MO_2$ and L.A.O where M is at least one metal of the group Ba, Mg, Ca, and Sr; O is oxygen; L is at least one metal of the rare earth group, including scandium and yttrium; A is at least one metal of the group Cu, Ag, and Au; and L.A.O is a pre-calcined mixture of L oxide and A oxide; where L:M:A is present in a respective atomic ratio of about a:b:c, where a is about 0.8 - 2.2, b is about 1.8 - 2.2, and c is about 2.7 - 3.3.

6. Composition according to Claim 5, where a is about 1, b is about 2, and c is about 3.

7. Composition according to Claim 6, where L is yttrium, M is barium, and A is copper.

8. Process comprising heat treating a shape to cause it to become superconducting, said shape consisting essentially of an adhered intimate mixture of powdered $MO_2$, L oxide, and A oxide, where M is at least one metal of the group Ba, Mg, Ca, and Sr; O is oxygen; L is at least one metal of the rare earth group, including scandium and yttrium; A is at least one metal of the group Cu, Ag, and Au; where L:M:A is present in a respective atomic ratio of about a:b:c, where a is about 0.8 - 2.2, b is about 1.8 - 2.2, and c is about 2.7 - 3.3.

9. Process according to Claim 8 in which a is about 1, b is about 2, and c is about 3.

10. Process according to Claim 9 in which L is yttrium, M is barium, and A is copper.

11. Process according to Claim 10 in which L oxide and A oxide are precalcined together.

12. Process according to Claim 8, 9, 10, or 11 wherein the heat treatment is carried out in oxygen or air, at about 925 - 1,025 $^\circ$ C, for about 1 - 2 hours.

Claims for the following Contracting State: ES

1. Process comprising heat treating a shape to cause it to become superconducting, said shape consisting essentially of an adhered intimate mixture of powdered $MO_2$, L oxide, and A oxide, where M is at least one metal of the group Ba, Mg, Ca, and Sr; O is oxygen; L is at least one metal of the rare earth group, including scandium and yttrium; A is at least one metal of the group Cu, Ag, and Au; where L:M:A is present in a respective atomic ratio of about a:b:c, where a is about 0.8 - 2.2, b is about 1.8 - 2.2, and c is about 2.7 - 3.3.

2. Process according to Claim 1 in which a is about 1, b is about 2, and c is about 3.

3. Process according to Claim 2 in which L is yttrium, M is barium, and A is copper.

4. Process according to Claim 3 in which L oxide an A oxide are precalcined together.

5. Process according to Claim 1, 2, 3 or 4 wherein the heat treatment is carried out in oxygen or air, at about 925 - 1,025°C, for about 1 - 2 hours.

6. Shape adapted to become superconducting by heat treatment, said shape consisting essentially of an adhered intimate mixture of powdered $MO_2$, L oxide, and A oxide, where M is at least one metal of the group Ba, Mg, Ca, and Sr; O is oxygen; L is at least one metal of the rare earth group, including scandium and yttrium; A is at least one metal of the group Cu, Ag, and Au; where L:M:A is present in a respective atomic ratio of about a:b:c, where a is about 0.8 - 2.2, b is about 1.8 - 2.2, and c is about 2.7 - 3.3.

7. Shape according to Claim 6 in which a is about 1, b is about 2, and c is about 3.

8. Shape according to Claim 7 in which L is yttrium, M is barium, and A is copper.

9. Shape according to Claim 6 wherein L oxide and A oxide are precalcined together.

10. Powdered composition consisting of intimate mixture of $MO_2$ and L.A.O where M is at least one metal of the group Ba, Mg, Ca, and Sr; O is oxygen; L is at least one metal of the rare earth group, including scandium and yttrium; A is at least one metal of the group Cu, Ag, and Au; and L.A.O is a pre-calcined mixture of L oxide and A oxide; where L:M:A is present in a respective atomic ratio of about a:b:c, where a is about 0.8 - 2.2, b is about 1.8 - 2.2, and c is about 2.7 - 3.3.

11. Composition according to Claim 10, where a is about 1, b is about 2, and c is about 3.

12. Composition according to Claim 11, where L is yttrium, M is barium, and A is copper.